# EUROPEAN PATENT APPLICATION

(11) **EP 3 176 598 A1**
(43) Date of publication of application: **07.06.2017**
(21) Application number: 16198522.1
(22) Date of filing: 11.11.2016
(51) Int. Cl.: G01S 1/24, G01R 29/08, G01W 1/16

(54) **LOW FREQUENCY/MEDIUM FREQUENCY (LF/MF) MULTI MODE ANTENNA/RECEIVER**

(30) Priority: 02.12.2015 US 201514957390
(71) Applicant: Honeywell International Inc., Morris Plains, NJ 07950 (US)
(72) Inventor: YAKUBISIN, Kyle, Morris Plains, NJ 07950 (US); DOYLE, Robert S., Morris Plains, NJ 07950 (US); MALAGA, Alfonso, Morris Plains, NJ 07950 (US)
(74) Representative: Houghton, Mark Phillip

(57) **Abstract**

An antenna receiver system includes an E-field antenna (120), a first H-field antenna (111), a second H-field antenna (112); three antenna radio frequency paths (301, 302, 303, 306, 307, 308) to amplify, filter, and convert three respective outputs from the three antennas to respective first (371), second (372), and third (373) signals. Filters in the antenna paths simultaneously receive at least two of: eLORAN radio navigation signals from eLORAN ground stations; an EM pulse from lightning; and one of: CW unmodulated signals; ON/OFF modulated signals from a NDB radio navigation ground station; or an AM CW signal received from an AM radio broadcast station. A processor (340) processes the first, second, and third signals and outputs information indicative of two or more of: a geographical latitude and longitude position of the vehicle derived from the eLORAN radio navigation signals; a lightning bearing and a lightning range; and a bearing of the vehicle.

## Description

### BACKGROUND

Instances of Global Position System (GPS) jamming and GPS outages have been increasing so it is becoming more important to have an alternate (backup) source of position and time in navigation systems. Enhanced LOng RANge (eLORAN) has been proposed as an alternate source of Precision Navigation and Time (aPNT) for airborne and marine applications. The eLORAN radio navigation signals are high-power, low-frequency and are used in systems that operate at 100.000 kHz. Adding eLORAN capabilities to an existing vehicle (e.g., an aircraft or a ship) can be expensive because eLORAN requires a new antenna and new navigation receiver hardware. When an antenna is added to a vehicle, the vehicle structure is modified, which is expensive. An additional antenna adds aerodynamic drag to the vehicle.

### SUMMARY

The present application relates to an antenna receiver system including: an E-field antenna on a vehicle with an omni-azimuth pattern; a first H-field antenna on the vehicle with a cosine azimuth pattern with reference to a vehicle orientation in a forward direction; a second H-field antenna on the vehicle with a sine azimuth pattern with reference to the vehicle orientation in the forward direction; a first antenna radio frequency path to amplify, filter, and convert a first output from the first H-field antenna to first signals; a second antenna radio frequency path to amplify, filter, and convert a second output from the second H-field antenna to second signals; a third antenna radio frequency path to amplify, filter, and convert a third output from the E-field antenna to third signals. Filters in the first, second, and third antenna radio frequency paths are sufficiently wide to simultaneously receive at least two of: eLORAN radio navigation signals received from eLORAN ground stations; an electromagnetic (EM) pulse from lightning within a range of the vehicle; and one of: continuous wave (CW) unmodulated signals received from a Non-Directional Beacons (NDB) radio navigation ground station; ON /OFF modulated signals received from the NDB radio navigation ground station; or an amplitude modulated (AM) CW signal received from an AM radio broadcast station. The antenna receiver system also includes at least one processor configured to process the first, second, and third signals and output information indicative of two or more of: a geographical latitude and longitude position of the vehicle derived from the eLORAN radio navigation signals received from three or more eLORAN ground stations; when lightning occurs within a range of the vehicle, a lightning bearing and a lightning range from the vehicle; and a bearing of the vehicle from one of the NDB radio navigation ground station or the AM radio broadcast station.

### DRAWINGS

Understanding that the drawings depict only exemplary embodiments and are not therefore to be considered limiting in scope, the exemplary embodiments will be described with additional specificity and detail through the use of the accompanying drawings, in which:
Figure 1 shows an embodiment of an antenna receiver system on a vehicle with reference to ground stations in accordance with the present application;
Figure 2 shows an embodiment of an antenna receiver system on vehicles with reference to ground stations in accordance with the present application;
Figure 3 shows an embodiment of an antenna receiver system on a vehicle in accordance with the present application;
Figure 4 shows an oblique view of an embodiment of a package containing an E-field antenna, a first H-field antenna, and a second H-field antenna in accordance with the present application;
Figure 5 shows a side view of an embodiment of the package of Figure 4;
Figure 6 shows an embodiment of an antenna receiver with three radio frequency paths and a digital processor in accordance with the present application;
Figure 7 shows an embodiment of an antenna receiver with three radio frequency paths and analog processors in accordance with the present application;
Figure 8 shows an embodiment of a method of implementing an antenna receiver system in accordance with the present application; and

In accordance with common practice, the various described features are not drawn to scale but are drawn to emphasize specific features relevant to the exemplary embodiments.

### DETAILED DESCRIPTION

In the following detailed description, reference is made to the accompanying drawings that form a part hereof, and in which is shown by way of illustration specific illustrative embodiments. However, it is to be understood that other embodiments may be utilized and that logical, mechanical, and electrical changes may be made. Furthermore, the method presented in the drawing figures and the specification is not to be construed as limiting the order in which the individual steps may be performed. The following detailed description is, therefore, not to be taken in a limiting sense.

This present application describes antenna receiver systems in which the eLORAN radio navigation signal reception is advantageously integrated with other antennas configured to receive other types of signals (e.g., automatic direction finders (ADF) antennas, and lightning detection antennas) that are already on a vehicle. In this manner, there is no need to alter the structure of the vehicle to add eLORAN radio navigation signal reception. The antenna receiver systems described herein receive, in a cost effective manner, two or more of eLORAN radio navigation signals, electro-magnetic (EM) pulses for lightning detection, and one of: CW unmodulated signals received from a NDB radio navigation ground station; ON /OFF modulated signals received from the NDB radio navigation ground station; or AM CW signals received from an AM radio broadcast station.

The existing antennas for automatic direction finders (ADF) have both vertically polarized electric field antennas and vertically polarized quadrature magnetic field antennas. The ADF antennas and amplifiers are inherently broad-band although it may be necessary to do some tuning to obtain optimal performance at 100.000 kHz used in eLORAN for the technology described herein. The ADF antennas are E and H antennas covering the range of 200-415 kHz for non directional beacon (NDB) or 550-1600 kHz for AM radio. Currently available lightning antennas are wideband, active E and H antennas. Currently available eLORAN antennas are E or H antennas with a 100.00 kHz center frequency and 20 kHz bandwidth.

In the past LORAN, ground stations have primarily provided navigation signals for ships near coastal areas or for navigation on the great lakes. The technology described herein permits the use of eLORAN signals as a back-up for GPS while implementing the ADF antennas and/or lightning antennas already on the vehicle. A loss of GPS signals could have serious financial consequences for the nation, so LORAN signals have been enhanced to add the broadcast of time (UTC) in addition to latitude and longitude so that eLORAN can be used as a back to GPS not just for navigation but also as a time source.

The technology described herein integrates the hardware, software, and firmware for older technologies of lightning detection and ADF with the newer technology, eLORAN. The antenna assembly includes a first H-field antenna, a second H-field antenna, and an E-field antenna, which are input to the same receiver that permits reception of all of desired signals (e.g., eLORAN radio navigation signals, EM pulses, and one or more of: CW unmodulated signals received from a NDB radio navigation ground station; ON /OFF modulated signals received from the NDB radio navigation ground station; or AM CW signals received from an AM radio broadcast station) by sampling and processing the entire band for all the signals. In one implementation of this embodiment, the three antennas and the receiver are housed together. In this type of implementation, the receiver is built into the antenna assembly so there is only one line-replaceable unit (LRU). In another implementation of this embodiment, the antennas and receiver are separate in more traditional systems. All embodiments of the technology described herein advantageously reduce the number of antennas on the vehicle body and reduce the number of LRUs in the vehicle. Specifically, there is no need for a separate ADF antenna, eLORAN antenna, and lightning detecting antenna to be attached to the vehicle. This reduces the drag due to multiple antennas on a vehicle.

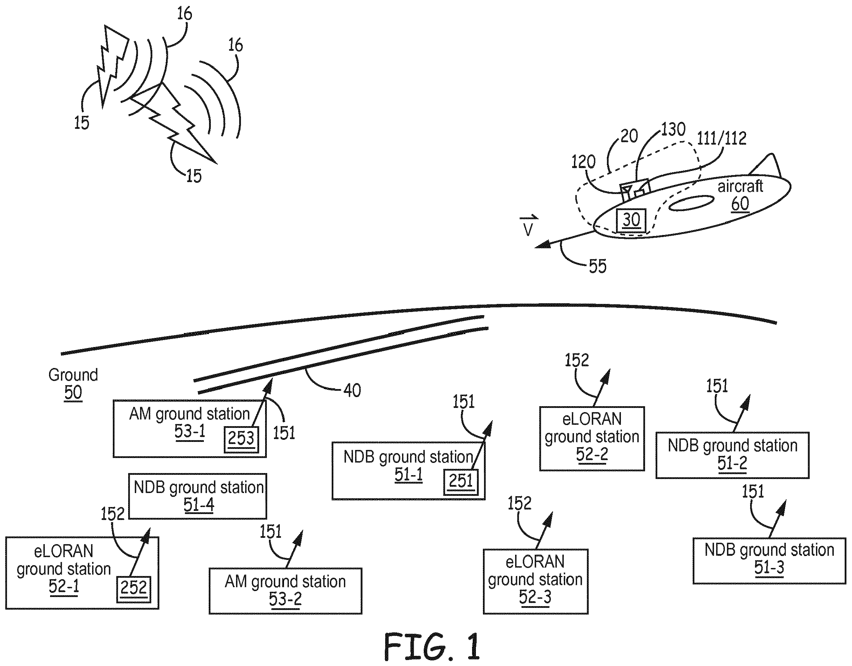

Figure 1 shows an embodiment of an antenna receiver system 20 on a vehicle 60 with reference to ground stations 51(1-4), 52(1-3), and 53-1 in accordance with the present application. In this exemplary embodiment, the vehicle 60 is an aircraft 60 approaching a landing strip 40 on the ground 50. Figure 1 shows the vehicle 60 in relationship with a vector V with numerical label 55. The vector V is also referred to herein as the "vehicle orientation in a forward direction 55" and is parallel to the length of the vehicle 60. The direction of travel of the vehicle 60 is not necessarily always the same as the vehicle orientation in a forward direction 55 since the vehicle 60 can experience some lateral movement (e.g., angle of attack, sideslip angle, and wind correction angle).

The ground stations 51(1-4), 52(1-3), and 53-1 include eLORAN ground stations 52(1-3), Non-Directional Beacons (NDB) radio ground stations 51(1-4), and an AM ground station 53-1.

The antenna receiver system 20 includes an antenna receiver 30, an E-field antenna 120 with an omni-azimuth pattern, a first H-field antenna 111 with a cosine azimuth pattern with reference to the vehicle orientation in the forward direction 55, and a second H-field antenna 112 with a sine azimuth pattern with reference to the vehicle orientation in the forward direction 55. The antenna receiver 30 is a low frequency/medium frequency (LF/MF) multimode antenna receiver 30 in a LF/MF multimode antenna receiver system 20.

The E-field antenna 120 receives signals arriving from any azimuth direction with an omni-azimuth pattern. The first H-field antenna 111 receives signals arriving from forward and aft of the vehicle 60 with a cosine azimuth pattern. As is well known in the art, forward of the vehicle 60 is in the direction of vector 55 and aft of the vehicle 60 is in the opposite the vector 55 behind the vehicle 60. The second H-field antenna 112 receives signals arriving from a starboard side of the vehicle 60 and a port side of the vehicle 60 with a sine azimuth pattern. As is well known in the art, the starboard side of the vehicle 60 is to the right side of the vehicle 60 for a person facing in the direction of vector 55; the port side of the vehicle 60 is to the left side of the vehicle 60 for a person facing in the direction of vector 55.

As shown in Figure 1, the first H-field antenna 111, the second H-field antenna 112, and the E-field antenna 120 are co-located in a single package 130 on a vehicle 60. The E-field antenna 120, the first H-field antenna 111, the second H-field antenna 112 are communicatively coupled to the antenna receiver 30. The antenna receiver 30 includes a processor and three radio frequency paths, which are described in detail below. In the exemplary embodiment shown in Figure 1, the antenna receiver 30 is separate from the package 130 housing the first H-field antenna 111, the second H-field antenna 112, and the E-field antenna 120. In another implementation of this embodiment, the first H-field antenna 111, the second H-field antenna 112, and the E-field antenna 120 are not co-located with each other.

The eLORAN ground stations 52(1-3), NDB radio navigation ground stations 51(1-4), and the AM ground station 53-1 are on the ground 50.

The NDB radio navigation ground stations 51(1-4) include a ground navigation-aid transmitter 251 (shown in NDB radio navigation ground station 52-1) that emits either continuous wave (CW) unmodulated signals 151 or ON /OFF modulated signals 151. The CW unmodulated signals 151 or the ON /OFF modulated signals 151 are shown as arrows, which are representative of signals broadcast in all directions from the respective NDB radio navigation ground stations 51(1-4). The "ground navigation-aid transmitter 251" is also referred to herein as "a first ground navigation-aid transmitter 251". Typically, the NDB radio navigation ground stations 51(1-4) operate between 190 kHz and 525 kHz and between 1625 kHz and 1800 kHz. The NDB radio navigation ground stations 51(1-4) are located at specific locations as required for navigation. For example, a NDB radio navigation ground stations 51(1-4) is positioned for use during landing to provide the 'final approach fix' for the runway 40, as shown in Figure 1. The NDB radio navigation ground stations 51(1-4) are built, sited, and maintained by the FAA to provide airborne navigation.

The AM ground station 53-1 includes an AM transmitter 251 that emits AM CW signals 151. The AM CW signals 151 are shown an arrow, which is representative of signals broadcast in all directions from the AM ground station 53-1. The bearing of the vehicle 60 to one of the NDB radio navigation ground stations 51(1-4) or the AM radio broadcast station 53-1 is calculated by the antenna receiver system 20. Typically, AM ground stations (e.g., AM ground station 53-1) operate between 525 and 1625 kHz. The AM broadcast stations are used for airborne navigation but, since they are not at locations known to the pilots, they are only used for course navigation towards cities or towards land if flying over the ocean. For example, an aircraft 60 flying across the Caribbean may use AM broadcast stations for navigation because they emit very high power signals and thus provide navigation information for a very long distance.

The signals from the NDB radio navigation ground stations 51(1-4) and the AM ground station 53-1 are all indicated as signals 151, since they are all used by the technology described herein to provide a bearing of the vehicle 60 from ground station (i.e., one of the NDB radio navigation ground stations 51(1-4) or the AM radio broadcast station 53-1) emitting the signal 151.

The eLORAN ground stations 52(1-3) each include a second ground navigation-aid transmitter 252 (shown in eLORAN ground stations 52-1) that emits eLORAN radio navigation signals 152. Three or more LORAN radio navigation eLORAN radio navigation signals 152 from three or more respective eLORAN ground stations 52(1-3) are used to determine a position of the vehicle 60. The vehicle 60 receives signals from three eLORAN ground stations 52(1-3) and triangulates the vehicle position by measuring the time difference of arrival of the signals received from the three eLORAN ground stations 52(1-3). In this manner, the eLORAN radio navigation signals 152 are used to determine a precise geographic location (i.e., latitude and longitude) of the vehicle 60. This is the same principle used by global positioning system (GPS) and was derived from early LORAN. The vehicle 60 must have information about the precise geographic location of the eLORAN transmitting ground stations 52(1-3) from which the eLORAN radio navigation signals 152 are received in order to determine its own location. The geographic latitude and longitude of the eLORAN transmitting ground stations 52(1-3) is encoded on the sequence of pulses emitted as eLORAN radio navigation signals 152 by each eLORAN ground station 52(1-3). The eLORAN ground station 52(1-3) are strategically located to provide coverage over wide geographic areas and do not have to be located at airports. It is more important that they be carefully planned so that at least three eLORAN ground stations are within range over the desired coverage area. When eLORAN radio navigation signals 152 are used as a back-up for GPS, the coverage area is the continental United States.

The eLORAN radio navigation signals 152 described herein are any one of the various types of bearing signals that are transmitted and received based on the specified standards for standard LORAN (LORAN-A), LORAN-B, cyclan LORAN (LORAN-C), or future -developed LORAN. The eLORAN radio navigation signals 152 emitted by the eLORAN ground stations 52(1-3) are high power, low frequency (100 kHz) signals that are received by vehicles between up to 500 to 1000 miles from the eLORAN ground stations 52(1-3).

Figure 1 shows an EM pulse 16 emitted from lightning 15. If the lighting 15 is within a range of the vehicle 60, the EM pulse 16 is received at the first H-field antenna 111, the second H-field antenna 112, and the E-field antenna 120. The range of the vehicle 60 is a function of the sensitivity of the receiver.

The antenna receiver system 20 simultaneously receives at least two of: eLORAN radio navigation signals 152; an electromagnetic (EM) pulse 16 from lightning within a range of the vehicle 60; and one of: the CW unmodulated signals 151 received from one of the NDB radio navigation ground stations 51-1, 51-2, 51-3, and 51-4; the ON /OFF modulated signals 151 received from one of the NDB radio navigation ground stations 51-1, 51-2, 51-3, and 51-4; or the AM CW signal 151 received from the AM radio broadcast station 53-1.

The E-field antenna 120 receives signals 151, 152, and any EM pulse 16 arriving from any azimuth direction with an omni-azimuth pattern. An omnidirectional E-field antenna 120 on the vehicle 60 receives signals 151, 152, and EM pulse 16 (if present) from all directions (in azimuth) equally well. The first H-field antenna 111 receives signals 151, 152, and any EM pulse 16 arriving from forward and aft of the vehicle 60 with a cosine azimuth pattern. The second H-field antenna 112 receives signals 151, 152, and any EM pulse 16 arriving from the starboard side and the port side of the vehicle at a first H-field antenna with a sine azimuth pattern.

The E-field antenna 120 has an omni-directional radiation pattern on the plane perpendicular to the axis (length) of the E-field antenna 120. Therefore it can transmit equal energy in all directions perpendicular to the axis of the antenna 120 or receive signals arriving from all directions perpendicular to the axis of the antenna 120 with equal gain. The first H-field antenna 111 and the second H-field antenna 112 have a gain pattern that is proportional to the cosine of angle of arrival or sine of angle of arrival, respectively. Gain of the first H-field antenna 111 and second H-field antenna 112 is proportional to the directivity times a constant, which is proportional to the dimensions of the loops in the first H-field antenna 111 and second H-field antenna 112 and number of turns in the loop and the wavelength/ frequency of the signal being received. The gain of the H-field antennas 111/112 is proportional to the cosine or sine of the azimuth of the angle of arrival of the eLORAN radio navigation signals 152, the signals 151, and the EM pulses 16.

The sine gain pattern has a null at 0 degrees and 180 degrees relative to the axis of the loops of the first H-field antenna 111 and second H-field antenna 112 and unity directivity at azimuth angles 90 degrees and 270 degrees relative to the axis of the loops of the first H-field antenna 111 and second H-field antenna 112.

The first H-field antenna 111 (i.e., the cosine antenna 111) preferentially receives signals originating from in front of or behind the vehicle 60. The second H-field antenna 112 (i.e., the sine antenna 112) preferentially receives signals 151, 152, and any EM pulse 16 from the left (port) side or right (starboard) side of the vehicle 160. The directivity at the in-between angles follows the sine of the angle. At the frequencies of interest, the maximum gain at 90 degrees or 270 degrees is much less than 1.

In one implementation of this embodiment, the first H-field antenna 111 and the second H-field antenna 112 are combined in a cross-loop antenna in which the axes of the two multi-turn-loop antennas 111 and 112 are oriented orthogonally to each other, i.e., the sine and cosine loops are at 90 degrees to each other. It is common to wind these loops around a ferrite brick. A loop antenna has, by definition, a sine-shaped radiation pattern as a function of the angle of radiation or reception relative to the axis of the loop. So two orthogonally oriented loop antennas have sine patterns about their axis or, if the axis of one antenna is used as the common reference point of the loops, is said to have a sine-shaped radiation pattern and the other perpendicular loop has a cosine-shaped radiation pattern.

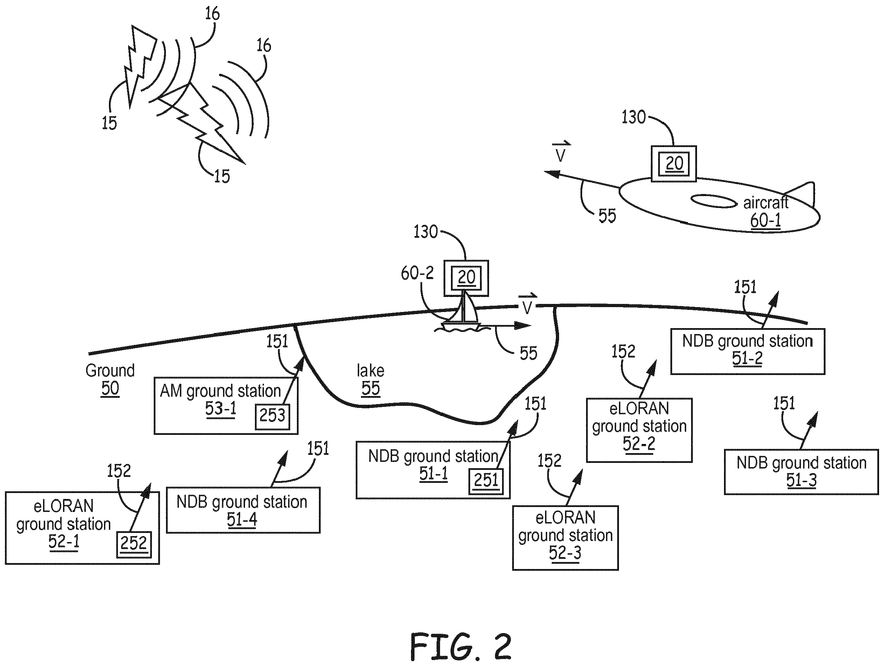

Figure 2 shows an embodiment of an antenna receiver system 20 on vehicles 60-1 and 60-2 with reference to ground stations 51(1-4), 52(1-3), and 53(1-2) in accordance with the present application. Vehicle 60-1 is an aircraft. Vehicle 60-2 is a water-based vehicle, which is shown in Figure 2 on a lake 55. The antenna receiver system 20 in Figure 2 differs from the antenna receiver system 20 in Figure 1 in that the antenna receiver 30 is inside the package 130 in proximity with the first H-field antenna 111, the second H-field antenna 112, and the E-field antenna 120.

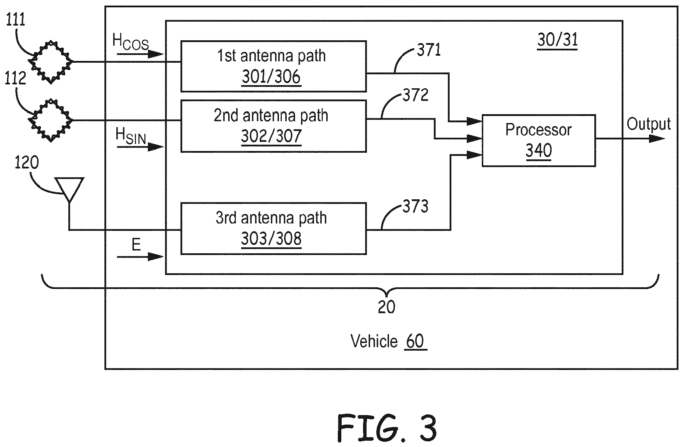

Figure 3 shows an embodiment of an antenna receiver system 20 on a vehicle 60 in accordance with the present application. The antenna receiver system 20 includes the first H-field antenna 111, the second H-field antenna 112, and an E-field antenna 120 communicatively coupled to the antenna receiver 30/31. The antenna receiver 30 (or alternately antenna receiver 31) includes at least one processor 340 and three radio frequency paths 301, 302, and 303 (or alternately radio frequency paths 306, 307, and 308) each having one or more stages of amplification.

A first antenna radio frequency path 301/306 amplifies, filters, and converts a first output H_{cos} from the first H-field antenna 111 to first signals 371. A second antenna radio frequency path 302/307 amplifies, filters, and converts a second output Hₛᵢₙ from the second H-field antenna 112 to second signals 372. A third antenna radio frequency path 303/308 amplifies, filters, and converts a third output E from the E-field antenna 120 to third signals 373.

The filters in the first, second, and third antenna radio frequency paths 301-303 (or 306-308) are sufficiently wide to simultaneously receive at least two of: eLORAN radio navigation signals 152 received from at least three eLORAN ground stations 52(1-3); an EM pulse 16 from lightning 15 within a range of the vehicle 60; and one of: CW unmodulated signals 151 received from one of the NDB radio navigation ground stations 51-1, 51-2, 51-3, and 51-4; ON /OFF modulated signals 151 received from the one of the NDB radio navigation ground stations 51-1, 51-2, 51-3, and 51-4; or AM CW signals 151 received from one of the AM radio broadcast stations 53(1-2). Typically, NDB radio navigation ground stations 51-1, 51-2, 51-3, and 51-4 emit either CW unmodulated signals 151 or ON /OFF modulated signals 151. The filters in the first, second, and third antenna radio frequency paths 301-303 (or 306-308) that are sufficiently wide to simultaneously receive CW unmodulated signals 151 received from one of the NDB radio navigation ground stations 51-1, 51-2, 51-3, and 51-4 are also sufficiently wide to simultaneously receive ON /OFF modulated signals 151 received from another one of the NDB radio navigation ground stations 51-1, 51-2, 51-3, and 51-4.

The processor 340 represents at least one processor that is configured to process the first signals 371, the second signals 372, and the third signals 373. The at least one processor 340 outputs information indicative of two or more of: geographical latitude and longitude position of the vehicle 60 derived from the eLORAN radio navigation signals 152 received from three or more eLORAN ground stations 52(1-3); when lightning 15 occurs within a range of the vehicle 60, a bearing of the lightning 15 (i.e., a lightning bearing) from the vehicle 60, and a range of the lightning 15 (i.e., a lightning range) from the vehicle 60; and a bearing of the vehicle from one of the NDB radio navigation ground station 52-1 or the AM radio broadcast station 53-1.

As noted above, the geographical latitude and longitude position of the vehicle 60 is derived from eLORAN radio navigation signals 152 received from three or more eLORAN ground stations 52(1-4) that each include a second ground navigation-aid transmitter 252 that emits the eLORAN radio navigation signals 152. The bearing of the vehicle 60 is derived from one of a first ground navigation-aid transmitter 251 in a ground station 51 emitting the CW unmodulated signals 151 or ON/OFF modulated signals 151, or from an AM transmitter 253 in an AM ground station emitting AM CW signals 151. The term "CW unmodulated signals 151 or ON/OFF modulated signals 151" is referred to herein as "CW unmodulated signals-ON/OFF modulated signals 151". The information indicative of bearing and position is generated independent of a GPS system and thus the antenna receiver system 20 can be used as a backup navigation system in the event that GPS is jammed or otherwise unavailable to the vehicle 60.

In one implementation of this embodiment, the receiver system 30/31 includes filters in the first radio frequency path 301/306, second radio frequency path 302/307, and third antenna radio frequency path 303/308 that are sufficiently wide to simultaneously receive the CW unmodulated signals-ON/OFF modulated signals 151 and/or the AM CW signals 151 and the eLORAN radio navigation signals 150. In this case, the at least one processor 340 processes the first signal 371, the second signals 372, and the third signals 373 and outputs information indicative of: the geographical latitude and longitude position of the vehicle 60 derived from eLORAN radio navigation signals 152 received from the three or more eLORAN ground stations 52(1-3) that each include a second ground navigation-aid transmitter 252 that emits the eLORAN radio navigation signals 152; and a bearing of the vehicle 60 from one of a first ground navigation-aid transmitter 251 in a ground station 51 emitting the CW unmodulated signals-ON/OFF modulated signals 151, or from an AM transmitter 253 in an AM ground station emitting AM CW signals 151.

In another implementation of this embodiment, the receiver system 30/31 includes filters in the first radio frequency path 301/306, second radio frequency path 302/307, and third antenna radio frequency path 303/308 that are sufficiently wide to simultaneously receive the CW unmodulated signals-ON/OFF modulated signals 151 and/or the AM CW signals 151 and the EM pulse 16 from the lightning 15 occurring within the range of the vehicle 60. In this case, the at least one processor 340 processes the first signals 371, the second signals 372, and the third signals 373 and outputs information indicative of: a bearing of the vehicle 60 from one of a first ground navigation-aid transmitter 251 in a ground station 51 emitting the CW unmodulated signals-ON/OFF modulated signals 151, or from an AM ground station emitting AM CW signals 151 from an AM transmitter 253; and when the lightning 16 occurs within the range of the vehicle 60, the lightning bearing and the lightning range from the vehicle 60.

In yet another implementation of this embodiment, the receiver system 30/31 includes filters in the first radio frequency path 301/306, second radio frequency path 302/307, and third antenna radio frequency path 303/308 that are sufficiently wide to simultaneously receive the eLORAN radio navigation signals 152 and the EM pulse 16 from the lightning 15 occurring within the range of the vehicle 60. In this case, the at least one processor 340 processes the first signals 371, the second signals 372, and the third signals 373 and outputs information indicative of: the geographical latitude and longitude position of the vehicle 60 derived from eLORAN radio navigation signals 152 received from the three or more eLORAN ground stations 52(1-3) that each include a second ground navigation-aid transmitter 252 that emits the eLORAN radio navigation signals 152; and when the lightning 16 occurs within the range of the vehicle 60, the lightning bearing and the lightning range from the vehicle 60.

In yet another implementation of this embodiment, the receiver system 30/31 includes filters in the first radio frequency path 301/306, second radio frequency path 302/307, and third antenna radio frequency path 303/308 that are sufficiently wide to simultaneously receive the CW unmodulated signals-ON/OFF modulated signals 151 and/or the AM CW signals 151, the eLORAN radio navigation signals 152, and the EM pulse 16 from the lightning 15 occurring within the range of the vehicle 60. In this case, the at least one processor 340 processes the first signals 371, the second signals 372, and the third signals 373 and outputs information indicative of: the geographical latitude and longitude position of the vehicle 60 derived from eLORAN radio navigation signals 152 received from the three or more eLORAN ground stations 52(1-3) that each include a second ground navigation-aid transmitter 252 that emits the eLORAN radio navigation signals 152; when the lightning 16 occurs within the range of the vehicle 60, the lightning bearing and the lightning range from the vehicle 60; and a bearing of the vehicle 60 from one of a first ground navigation-aid transmitter 251 in a ground station 51 emitting the CW unmodulated signals-ON/OFF modulated signals 151, or from an AM transmitter 253 in an AM ground station emitting AM CW signals 151.

The processor 340 can be a field programmable gate array (FPGA), a digital signal processor (DSP), a micro-processor, a microcontroller, a central processing unit (CPU), or a microcomputer. In one implementation of this embodiment, the processor 340 is configured to process eLORAN radio navigation signals 152 according to one of the LORAN, LORAN-A, LORAN-B, LORAN-C, or future developed LORAN standards. In another implementation of this embodiment, the processor 340 is configured to process eLORAN radio navigation signals 152 according to two or more of the LORAN, LORAN-A, LORAN-B, LORAN-C, or future developed LORAN standards.

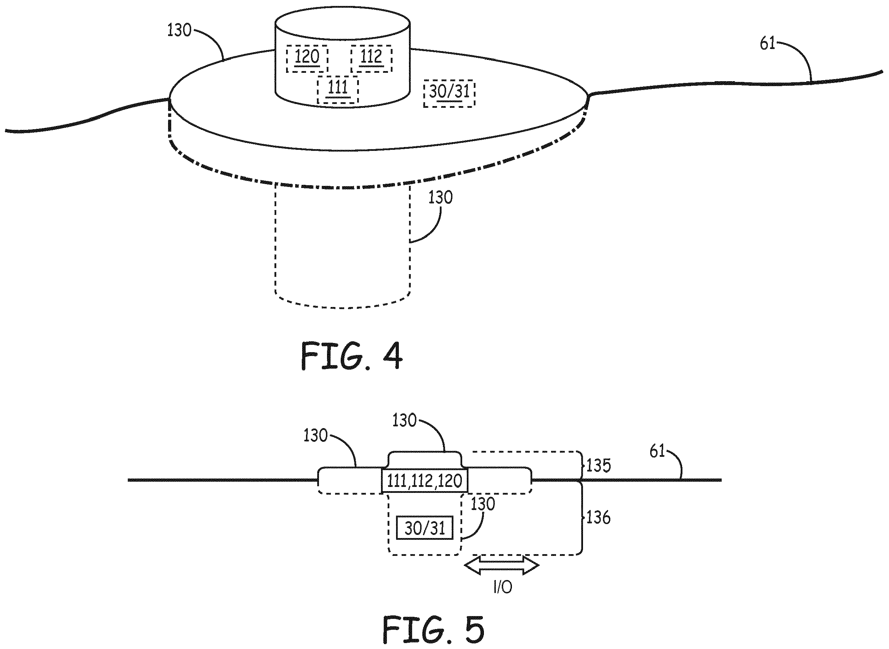

Figure 4 shows an oblique view of an embodiment of a package 130 containing a first H-field antenna 111, a second H-field antenna 112, and an E-field antenna 120 in accordance with the present application. In the embodiment of antenna receiver system 20 shown in Figure 4, the first H-field antenna 111 and second H-field antenna 112, the E-field antenna 120, first antenna radio frequency path 301/306, the second antenna radio frequency path 302/307, the third antenna radio frequency path 303/308, and the processor 340 are co-located in a package 130.

Figure 5 shows a side view of an embodiment of the package of Figure 4. As shown in Figure 5, a first portion 135 of the package 130 protrudes through the outer surface 61 or skin 61 of the vehicle 60 and a second portion 136 of the package 130 is internal to the vehicle 60. The first H-field antenna 111, the second H-field antenna 112, and the E-field antenna 120 are positioned within the first portion 135 so that they are exposed to the CW unmodulated signals-ON/OFF modulated signals 151 and/or the AM CW signals 151, the eLORAN radio navigation signals 152, and any EM pulse 16 emitted from lightning 15 within a range of the vehicle 60. At least the first portion 135 of the package 130 is formed from a material that transmits the CW unmodulated signals-ON/OFF modulated signals 151 and/or the AM CW signals 151, the eLORAN radio navigation signals 152, and the EM pulse 16. The package 130 shown in Figures 4 and 5 includes the antenna receiver 30/31, which functions as a system input output (I/O). In one implementation of this embodiment, the package 130 is an LRU. In another implementation of this embodiment, the antenna receiver 30/31 is external to the package 130. In yet another implementation of this embodiment, the shape of the package 130 is designed for reduced drag on the vehicle 60. For example and as shown in Figure 4, the periphery of the package 130 at the intersection with the skin 61 has a tear drop shape with low wind resistance. Other shapes are possible.

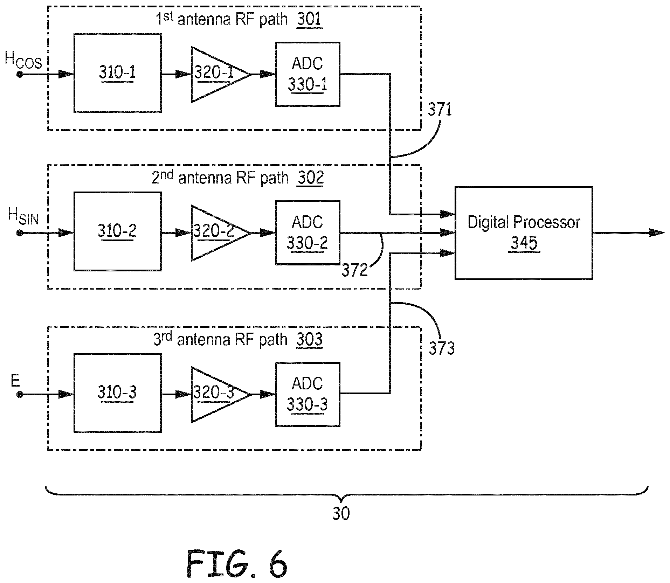

Figure 6 shows an embodiment of an antenna receiver 30 with three radio frequency paths 301-303 and a digital processor 345 in accordance with the present application. The first antenna radio frequency path 301 includes a first filter 310-1, a first amplifier 320-1, and a first analog-to-digital convertor 330-1. The first filter 310-1 inputs the first output H_{cos} from the first H-field antenna 111. The first filter 310-1 outputs signals to the first amplifier 320-1, the first amplifier 320-1 outputs signals to the first analog-to-digital convertor 330-1, and the first analog-to-digital convertor 330-1 outputs the first digital signals 371 to the digital processor 345.

The second antenna radio frequency path 302 includes a second filter 310-2, a second amplifier 320-2, and a second analog-to-digital convertor 330-2. The second filter 310-2 inputs the second output Hₛᵢₙ from the second H-field antenna 112. The second filter 310-2 outputs signals to the second amplifier 320-2, the second amplifier 320-2 outputs signals to the second analog-to-digital convertor 330-2, and the second analog-to-digital convertor 330-2 outputs the second digital signals 372 to the digital processor 345.

The third antenna radio frequency path 303 includes a third filter 310-3, a third amplifier 320-3, and a third analog-to-digital convertor 330-3. The third filter 310-3 inputs the output E from the E-field antenna 120. The third filter 310-3 outputs signals to the third amplifier 320-3, the third amplifier 320-3 outputs signals to the third analog-to-digital convertor 330-3, and the third analog-to-digital convertor 330-3 outputs the third digital signals 373 to the digital processor 345. The signals 371-372 are communicated to the digital processor 345 by any type of communication link including wired links and/or wireless links.

The filters described herein are designed to pass at least one frequency region for the signals based on the function of the antenna receiver system 20. In one implementation of this embodiment, the filters 310-1, 310-2, and 310-3 described herein are configured to filter a pass band having a range of 90 kHz through 1600 kHz. In another implementation of this embodiment, the amplifiers are low noise amplifiers (LNAs). In yet another implementation of this embodiment, at least one of the three radio frequency paths 301-303 include two filters and two amplifiers to double-filter the signals.

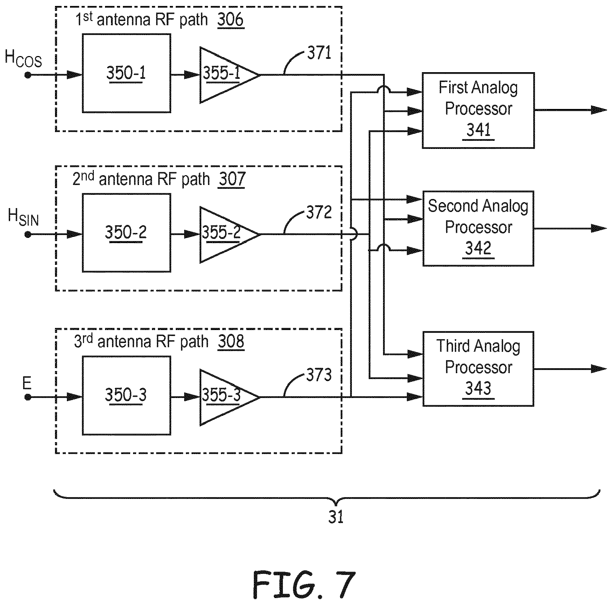

Figure 7 shows an embodiment of an antenna receiver with three radio frequency paths 306-308 and three analog processors 340 in accordance with the present application. The radio frequency paths 306-308 do not include analog-to-digital convertors.

The first antenna radio frequency path 306 includes a first filter 350-1 and a first amplifier 355-1. The first filter 350-1 inputs the first output H_{cos} from the first H-field antenna 111. The first filter 350-1 outputs signals to the first amplifier 355-1 and the first amplifier 355-1 outputs the first analog signals 371 to the first analog processor 341, the second analog processor 342, and the third analog processor 343.

The second antenna radio frequency path 307 includes a second filter 350-2 and a second amplifier 355-2. The second filter 350-2 inputs the second output Hₛᵢₙ from the second H-field antenna 112. The second filter 350-2 outputs signals to the second amplifier 355-2 and the second amplifier 355-2 outputs second analog signals 372 to the first analog processor 341, the second analog processor 342, and the third analog processor 343.

The third antenna radio frequency path 308 includes a third filter 350-3 and a third amplifier 355-3. The third filter 350-3 inputs the output E from the E-field antenna 120. The third filter 350-3 outputs signals to the third amplifier 355-3 and the third amplifier 355-3 outputs third analog signals 373 to the to the first analog processor 341, the second analog processor 342, and the third analog processor 343.

The first analog processor 341 processes the first, second, and third signals 371-373 from the respective first antenna radio frequency path 306, second antenna radio frequency path 307, and the third antenna radio frequency path 308 and outputs the information indicative of the bearing of the vehicle 60 from one of: a NDB radio navigation ground station 51-1, 51-2, 51-3, or 51-4: or the AM radio broadcast station 53-1 (Figures 1 and 2).

The second analog processor 342 processes the first, second, and third signals 371-373 from the respective first antenna radio frequency path 306, second antenna radio frequency path 307, and the third antenna radio frequency path 308 and outputs information indicative of the geographical latitude and longitude position of the vehicle 60 derived from the eLORAN radio navigation signals 152 received from the three or more eLORAN ground stations 52(1-3) that each include a second ground navigation-aid transmitter 252 that emits the eLORAN radio navigation signals 152.

The third analog processor 343 processes the first, second, and third signals from the respective first antenna radio frequency path 306, second antenna radio frequency path 307, and the third antenna radio frequency path 308 and outputs the information indicative of the lightning bearing and the lightning range from the vehicle 60, when lightning 15 occurs within a range of the vehicle 60.

The receiver system 31 shown in Figure 7 includes filters 350-1, 350-2, and 350-3 in the respective first radio frequency path 306, second radio frequency path 307, and third antenna radio frequency path 308 that are sufficiently wide to simultaneously receive the CW unmodulated signals-ON/OFF modulated signals 151 and/or the AM CW signals 1511, the eLORAN radio navigation signals 152, and the EM pulse 16 from the lightning 15 occurring within the range of the vehicle 60. In other embodiments, the antenna receiver system does not receive all three of CW unmodulated signals-ON/OFF modulated signals 151 and/or the AM CW signals 151, eLORAN radio navigation signals 152, and EM pulses 16.

In one implementation of this embodiment, the receiver system 31 includes filters 350-1, 350-2, and 350-3 in the respective first radio frequency path 306, second radio frequency path 307, and third antenna radio frequency path 308 that are sufficiently wide to simultaneously receive to simultaneously receive the CW unmodulated signals-ON/OFF modulated signals 151 and/or the AM CW signals 151 and the EM pulse 16 from the lightning 15 occurring within the range of the vehicle 60, only two analog processors are required. In this case, the first analog processor 341 processes the first, second, and third signals 371-373 and outputs the information indicative of the bearing of the vehicle 60 from the first ground navigation-aid transmitter in the ground station 51 emitting signals 151; and the second analog processor 342 process the first, second, and third signals 371-373 and outputs the information indicative of the lightning bearing and the lightning range from the vehicle 60, when lightning 15 occurs within a range of the vehicle 60.

In another implementation of this embodiment, the receiver system 31 includes filters 350-1, 350-2, and 350-3 in the respective first radio frequency path 306, second radio frequency path 307, and third antenna radio frequency path 308 that are sufficiently wide to simultaneously receive to simultaneously receive the eLORAN radio navigation signals 152 and the EM pulse 16 from the lightning 15 occurring within the range of the vehicle 60, only two analog processors are required. In this case, the first analog processor 341 processes the first, second, and third signals 371-373 and outputs the information indicative of the geographical latitude and longitude position of the vehicle derived from the eLORAN radio navigation signals 152 received from the three or more eLORAN ground stations 52(1-4) that each include a second ground navigation-aid transmitter 252 that emits the eLORAN radio navigation signals 152; and the second analog processor 342 processes the first, second, and third signals 371-373 and outputs the information indicative of the lightning bearing and the lightning range from the vehicle 60, when lightning 15 occurs within a range of the vehicle 60.

In yet another implementation of this embodiment, the receiver system 31 includes filters 350-1, 350-2, and 350-3 in the respective first radio frequency path 306, second radio frequency path 307, and third antenna radio frequency path 308 that are sufficiently wide to simultaneously receive to simultaneously receive the CW unmodulated signals-ON/OFF modulated signals 151 and/or the AM CW signals 151 and eLORAN radio navigation signals 152, only two analog processors are required. In this case, the first analog processor 341 processes the first, second, and third signals 371-373 and outputs the information indicative of the bearing of the vehicle 60 from the first ground navigation-aid transmitter 251 in the ground station 51 emitting signals 151; and the second analog processor 342 process the first, second, and third signals and outputs the information indicative of the geographical latitude and longitude position of the vehicle derived from the eLORAN radio navigation signals 152 received from the three or more eLORAN ground stations 52(1-4) that each include a second ground navigation-aid transmitter 252 that emits the eLORAN radio navigation signals 152.

The antenna receiver 31 can be implemented with other radio frequency paths that filter and amplify the signals received from the antennas. In one implementation of this embodiment, the amplifiers 355(1-3) are low noise amplifiers (LNAs). In yet another implementation of this embodiment, at least one of the three radio frequency paths 306-308 include two filters and two amplifiers to double-filter the signals.

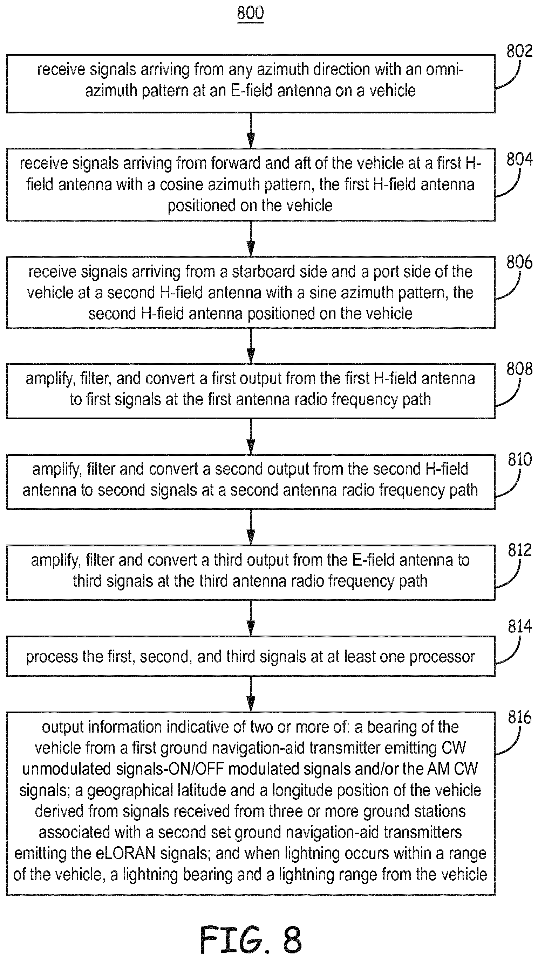

Figure 8 shows an embodiment of a method 800 of implementing an antenna receiver system 20 in accordance with the present application. The method 800 can be implemented using an antenna receiver system 20 configured to receive two or more of: 1) CW unmodulated signals-ON/OFF modulated signals 151 and/or the AM CW signals 151; 2) eLORAN radio navigation signals 152; and 3) EM pulses 16. The various embodiments of first H-field antenna 111, second H-field antenna 112, E-field antenna 120, and antenna radio frequency paths disclosed herein can be used in the antenna receiver system 20 that implements method 800. The method 800 is described with reference to Figures 1, 2, 6, and 7.

At block 802, signals arriving from any azimuth direction with an omni-azimuth pattern are received at an E-field antenna 120 on a vehicle 60. In one implementation of this embodiment, E-field antenna 120 receives CW unmodulated signals-ON/OFF modulated signals 151, eLORAN radio navigation signals 152, and EM pulses 16 arriving from any azimuth direction with an omni-azimuth pattern at an E-field antenna.

At block 804, signals arriving from forward and aft of the vehicle 60 at a first H-field antenna with a cosine azimuth pattern are received at a first H-field antenna 111 on the vehicle 60. In one implementation of this embodiment, first H-field antenna 111 receives CW unmodulated signals-ON/OFF modulated signals 151 and/or the AM CW signals 151, eLORAN radio navigation signals 152, and EM pulses 16 arriving from a direction of travel 55 of the vehicle 60 with a cosine azimuth pattern.

At block 806, signals arriving from a starboard side and a port side of the vehicle 60 with a sine azimuth pattern are received at a second H-field antenna 112 on the vehicle 60. In one implementation of this embodiment, second H-field antenna 112 receives CW unmodulated signals-ON/OFF modulated signals 151, eLORAN radio navigation signals 152, and EM pulses 16 arriving from a starboard side and a port side of the vehicle 60 with a sine azimuth pattern.

The antenna receiver system 20 simultaneously processes at least two of: 1) eLORAN radio navigation signals 152; 2) an EM pulse 16 from lightning 15 within a range of the vehicle 60; and 3) one of: CW unmodulated signals 151 received from a NDB radio navigation ground station 51; ON /OFF modulated signals 151 received from the NDB radio navigation ground station 51; or AM CW signals 151 received from an AM radio broadcast station 53. The antenna receiver system 20 simultaneously processes the signals in a first antenna radio frequency path 301/306, in a second antenna radio frequency path 302/307, and in a third antenna radio frequency path 302 308. This is done by process described in blocks 808-812.

At block 808, a first output H_{cos} from the first H-field antenna 111 is filtered, amplified, and converted to first signals 371 at the first antenna radio frequency path 301 or 306. If the first output Hₛᵢₙ is filtered, amplified, and converted at the first antenna radio frequency path 301, the process includes: outputting signals from the first filter 310-1 to the first amplifier 320-1; outputting signals from the first amplifier 320-1 to the first analog-to-digital convertor 330-1; and outputting the first digital signals 371 from the first analog-to-digital convertor 330-1 to the processor 345 (Figure 6).

At block 810, the second output Hₛᵢₙ from the second H-field antenna 112 is filtered, amplified, and converted to second signals 372 at the second antenna radio frequency path 302 or 307. If the second output Hₛᵢₙ is filtered, amplified, and converted to second digital signals at the second antenna radio frequency path 302, the process includes: outputting signals from the second filter 310-2 to the second amplifier 320-2; outputting signals from the second amplifier 320-2 to the second analog-to-digital convertor 330-2; and outputting the second digital signals 372 from the second analog-to-digital convertor 330-2 to the digital processor 345 (Figure 6).

At block 812, the output E from the E-field antenna 120 is filtered, amplified, and converted to third signals 373 at the third antenna radio frequency path 303 or 308. If the output E is filtered, amplified, and converted to third digital signals 373 at the third antenna radio frequency path 303, the process includes: outputting signals from the third filter 310-3 to the third amplifier 320-3; outputting signals from the third amplifier 320-3 to the third analog-to-digital convertor 330-3; and outputting the third digital signals 373 from the third analog-to-digital convertor 330-3 to the digital processor 345 (Figure 6).

At block 814, the first, second, and third signals 371-373 are processed at the processor 340. In one implementation of this embodiment, the first, second, and third digital signals 371-373 are processed at the digital processor 345 (Figure 6). In another implementation of this embodiment, the first, second, and third digital analog signals 371-373 are processed at the first analog processor 341, the second analog processor 342, and the third analog processor 343 (Figure 7).

At block 816, the at least one processor outputs information indicative of two or more of: 2) a bearing of the vehicle 60 from one of a first ground navigation-aid transmitter 251 in a ground station 51 emitting the CW unmodulated signals 151 or ON/OFF modulated signals 151, or from an AM transmitter 253 in an AM ground station emitting AM CW signals 151; 2) a geographical latitude and longitude position of the vehicle 60 derived from eLORAN radio navigation signals 152 received from three or more ground stations 52(1-4) that each include a second ground navigation-aid transmitter 252 that emits the eLORAN radio navigation signals 152; and 3) when lightning 15 occurs within a range of the vehicle 60, a lightning bearing and a lightning range from the vehicle. As described above, the antenna receiver system 20 of Figures 1-3 is able to process information from: 1) CW unmodulated signals-ON/OFF modulated signals 151 and/or the AM CW signals 151 and the eLORAN radio navigation signals 152; 2) CW unmodulated signals-ON/OFF modulated signals 151 and/or the AM CW signals 151 and EM pulses 16; 2) the eLORAN radio navigation signals 152 and EM pulses 16; or 3) CW unmodulated signals-ON/OFF modulated signals 151 and/or the AM CW signals 151, the eLORAN radio navigation signals 152, and EM pulses 16. The processing can be done for digital signals or analog signals.

Using the systems and methods described herein, there is no need to alter the structure of the vehicle 60 to permit eLORAN to be implemented with an automatic direction finder system. The antenna receiver systems 20 described with reference to method 800 implements eLORAN and automatic direction finders with the first H-field antenna 111, the second H-field antenna 112, and the E-field antenna 120, and the single antenna receiver 30 that has three parallel-processed radio frequency paths. In one implementation of this embodiment, the first H-field antenna 111, the second H-field antenna 112, and the E-field antenna 120 are co-located with each other. In another implementation of this embodiment, the first H-field antenna 111, the second H-field antenna 112, and the E-field antenna 120 are co-located with each other and with the single antenna receiver 30.

The processor 340 (Figure 3) includes or functions with software programs, firmware or other computer readable instructions for carrying out various methods, process tasks, calculations, and control functions, used in the antenna receiver system 20. The processor 340 executes algorithms and/or firmware that causes the processor 340 to perform at least some of the processing described here as being performed by the antenna receiver system 20. At least a portion of such algorithms and/or firmware executed by the antenna receiver system 20 and any related data structures are stored in storage medium during execution. Memory comprises any suitable memory now known or later developed such as, for example, random access memory (RAM), read only memory (ROM), and/or registers within the processor 340. In one implementation, the processor 340 comprises a microprocessor or microcontroller. In one implementation, the processor 340 comprises processor support chips and/or system support chips such as ASICs.

These instructions are typically stored on any appropriate computer readable medium used for storage of computer readable instructions or data structures. The computer readable medium can be implemented as any available media that can be accessed by a general purpose or special purpose computer or processor, or any programmable logic device. Suitable processor-readable media may include storage or memory media such as magnetic or optical media. For example, storage or memory media may include conventional hard disks, Compact Disk -Read Only Memory (CD-ROM), volatile or non-volatile media such as Random Access Memory (RAM) (including, but not limited to, Synchronous Dynamic Random Access Memory (SDRAM), Double Data Rate (DDR) RAM, RAMBUS Dynamic RAM (RDRAM), Static RAM (SRAM), etc.), Read Only Memory (ROM), Electrically Erasable Programmable ROM (EEPROM), and flash memory, etc. Suitable processor-readable media may also include transmission media such as electrical, electromagnetic, or digital signals, conveyed via a communication medium such as a network and/or a wireless link.

### Example Embodiments

Example 1 includes an antenna receiver system comprising: an E-field antenna on a vehicle with an omn-azimuth pattern; a first H-field antenna on the vehicle with a cosine azimuth pattern with reference to a vehicle orientation in a forward direction; a second H-field antenna on the vehicle with a sine azimuth pattern with reference to the vehicle orientation in the forward direction; a first antenna radio frequency path to amplify, filter, and convert a first output from the first H-field antenna to first signals; a second antenna radio frequency path to amplify, filter, and convert a second output from the second H-field antenna to second signals; a third antenna radio frequency path to amplify, filter, and convert a third output from the E-field antenna to third signals, wherein filters in the first, second, and third antenna radio frequency paths are sufficiently wide to simultaneously receive at least two of: eLORAN radio navigation signals received from eLORAN ground stations; an electromagnetic (EM) pulse from lightning within a range of the vehicle; and one of: continuous wave (CW) unmodulated signals received from a Non-Directional Beacons (NDB) radio navigation ground station; ON /OFF modulated signals received from the NDB radio navigation ground station; or an amplitude modulated (AM) CW signal received from an AM radio broadcast station; and at least one processor configured to process the first, second, and third signals and output information indicative of two or more of: a geographical latitude and longitude position of the vehicle derived from the eLORAN radio navigation signals received from three or more eLORAN ground stations; when lightning occurs within a range of the vehicle, a lightning bearing and a lightning range from the vehicle; and a bearing of the vehicle from one of the NDB radio navigation ground station or the AM radio broadcast station.
Example 2 includes the antenna receiver system of Example 1, wherein the filters in the first, second, and third antenna radio frequency paths are sufficiently wide to simultaneously receive the eLORAN radio navigation signals and one of: the CW unmodulated signals received from the NDB radio navigation ground station; the ON /OFF modulated signals received from the NDB radio navigation ground station; or the AM CW signal received from the AM radio broadcast station, and wherein the at least one processor is configured to process the first, second, and third signals and output the information indicative of: the bearing of the vehicle from one of the NDB radio navigation ground station or the AM radio broadcast station; and the geographical latitude and longitude position of the vehicle derived from the eLORAN radio navigation signals received from the three or more eLORAN ground stations.
Example 3 includes the antenna receiver system of Example 2, wherein the NDB radio navigation ground station includes a first ground navigation-aid transmitter, wherein the AM broadcast station includes an AM transmitter, and wherein the three or more eLORAN ground stations include three or more respective second ground navigation-aid transmitters that emit the eLORAN radio navigation signals.
Example 4 includes the antenna receiver system of any of Examples 2-3, wherein the at least one processor includes: a first analog processor configured to process the first, second, and third signals and output the information indicative of the bearing of the vehicle from one of the NDB radio navigation ground station or the AM radio broadcast station; and a second analog processor configured to process the first, second, and third signals and output the information indicative of the geographical latitude and longitude position of the vehicle derived from the eLORAN radio navigation signals received from the three or more eLORAN ground stations.
Example 5 includes the antenna receiver system of any of Examples 2-4, wherein the at least one processor is a digital processor.
Example 6 includes the antenna receiver system of any of Examples 1-5, wherein the filters in the first, second, and third antenna radio frequency paths are sufficiently wide to simultaneously receive the EM pulse from the lightning occurring within the range of the vehicle, and one of: the CW unmodulated signals received from the NDB radio navigation ground station; the ON /OFF modulated signals received from the NDB radio navigation ground station; or the AM CW signal received from the AM radio broadcast station, wherein the at least one processor is configured to process the first, second, and third signals and output the information indicative of: the bearing of the vehicle from one of the NDB radio navigation ground station or the AM radio broadcast station; and when the lightning occurs within the range of the vehicle, the lightning bearing and the lightning range from the vehicle.
Example 7 includes the antenna receiver system of Example 6, wherein the NDB radio navigation ground station includes a first ground navigation-aid transmitter, and the AM broadcast station includes an AM transmitter.
Example 8 includes the antenna receiver system of any of Examples 6-7, wherein the at least one processor includes: a first analog processor configured to process the first, second, and third signals and output the information indicative of the bearing of the vehicle from the one of the NDB radio navigation ground station or the AM radio broadcast station; and a second analog processor configured to process the first, second, and third signals and output the information indicative of the lightning bearing and the lightning range from the vehicle.
Example 9 includes the antenna receiver system of any of Examples 6-8, wherein the at least one processor is a digital processor.
Example 10 includes the antenna receiver system of any of Examples 1-9, wherein the filters in the first, second, and third antenna radio frequency paths are sufficiently wide to simultaneously receive the eLORAN radio navigation signals and the EM pulse from the lightning occurring within the range of the vehicle, wherein the at least one processor is configured to process the first, second, and third signals and output the information indicative of: the geographical latitude and longitude position of the vehicle derived from the eLORAN radio navigation signals received from the three or more eLORAN ground stations; and when the lightning occurs within the range of the vehicle, the lightning bearing and the lightning range from the vehicle.
Example 11 includes the antenna receiver system of Example 10, wherein the at least one processor includes: a first analog processor configured to process the first, second, and third signals and output the information indicative of the geographical latitude and longitude position of the vehicle derived from the eLORAN radio navigation signals received from the three or more eLORAN ground stations; and a second analog processor configured to process the first, second, and third signals and output the information indicative of the lightning bearing and the lightning range from the vehicle.
Example 12 includes the antenna receiver system of any of Examples 10-11, wherein the at least one processor is a digital processor.
Example 13 includes the antenna receiver system of any of Examples 1-12, wherein the filters in the first, second, and third antenna radio frequency paths are sufficiently wide to simultaneously receive the eLORAN radio navigation signals, the EM pulse from the lightning occurring within the range of the vehicle, and one of: the CW unmodulated signals received from the NDB radio navigation ground station; the ON /OFF modulated signals received from the NDB radio navigation ground station; or the AM CW signal received from the AM radio broadcast station, wherein the at least one processor is configured to process the first, second, and third signals and output the information indicative of: the bearing of the vehicle from one of the NDB radio navigation ground station or the AM radio broadcast station; the geographical latitude and longitude position of the vehicle derived from the eLORAN radio navigation signals received from the three or more eLORAN ground stations; and when the lightning occurs within the range of the vehicle, the lightning bearing and the lightning range from the vehicle.
Example 14 includes the antenna receiver system of Example 13, wherein the NDB radio navigation ground station includes a first ground navigation-aid transmitter, the AM broadcast station includes an AM transmitter, and wherein the three or more three or more eLORAN ground stations include three or more respective second ground navigation-aid transmitters.
Example 15 includes the antenna receiver system of any of Examples 13-14, wherein the at least one processor includes: a first analog processor configured to process the first, second, and third signals and output the information indicative of the bearing of the vehicle from one of the NDB radio navigation ground station or the AM radio broadcast station; a second analog processor configured to process the first, second, and third signals and output the information indicative of the geographical latitude and longitude position of the vehicle derived from the eLORAN radio navigation signals received from the three or more eLORAN ground stations; and a third analog processor configured to process the first, second, and third signals and output the information indicative of the lightning bearing and the lightning range from the vehicle.
Example 16 includes the antenna receiver system of any of Examples 13-15, wherein the at least one processor is a digital processor.
Example 17 includes a method of implementing an antenna receiver system, the method comprising: receiving signals arriving from any azimuth direction with an omni-azimuth pattern at an E-field antenna on a vehicle; receiving signals arriving from forward and aft of the vehicle at a first H-field antenna with a cosine azimuth pattern, the first H-field antenna positioned on the vehicle; receiving signals arriving from a starboard side and a port side of the vehicle at a second H-field antenna with a sine azimuth pattern, the second H-field antenna positioned on the vehicle simultaneously receiving at least two of: eLORAN radio navigation signals; an electromagnetic (EM) pulse from lightning within a range of the vehicle; and one of: the continuous wave (CW) unmodulated signals received from a Non-Directional Beacons (NDB) radio navigation ground station; the ON /OFF modulated signals received from the NDB radio navigation ground station; or amplitude modulated (AM) CW signals received from a AM radio broadcast station in a first antenna radio frequency path, in a second antenna radio frequency path, and in a third antenna radio frequency path by: amplifying, filtering, and converting a first output from the first H-field antenna to first signals at the first antenna radio frequency path; amplifying, filtering, and converting a second output from the second H-field antenna to second signals at the second antenna radio frequency path; and amplifying, filtering, and converting a third output from the E-field antenna to third signals at the third antenna radio frequency path.
Example 18 includes the method of Example 17, further comprising: processing at at least one processor the first, second, and third signals; and outputting from the at least one processor information indicative of two or more of: a bearing of the vehicle from one of the NDB radio navigation ground station or the AM radio broadcast station; a geographical latitude and longitude position of the vehicle derived from the eLORAN radio navigation signals received from the three or more eLORAN ground stations; and when lightning occurs within a range of the vehicle, a lightning bearing and a lightning range from the vehicle.
Example 19 includes an antenna receiver system comprising: an E-field antenna on a vehicle, the E-field antenna configured to receive signals arriving from any azimuth direction with an omni-azimuth pattern; a first H-field antenna on the vehicle, the first H-field antenna configured to receive signals arriving from forward and aft of the vehicle with a cosine azimuth pattern; a second H-field antenna on the vehicle, the second H-field antenna configured to receive signals arriving from a starboard side and a port side of the vehicle with a sine azimuth pattern; a first antenna radio frequency path to amplify, filter, and convert a first output from the first H-field antenna to first signals; a second antenna radio frequency path to amplify, filter, and convert a second output from the second H-field antenna to second signals; a third antenna radio frequency path to amplify, filter, and convert a third output from the E-field antenna to third signals, wherein filters in the first, second, and third antenna radio frequency paths are sufficiently wide to simultaneously receive: eLORAN radio navigation signals; an electromagnetic (EM) pulse from lightning within a range of the vehicle; and one of: a continuous wave (CW) unmodulated signals received from a Non-Directional Beacons (NDB) radio navigation ground station; ON /OFF modulated signals received from the NDB radio navigation ground station; or amplitude modulated (AM) CW signals received from an AM radio broadcast station; and at least one processor configured to process the first, second, and third signals and output information indicative of: a geographical latitude and longitude position of the vehicle derived from the eLORAN radio navigation signals received from three or more eLORAN ground stations; when lightning occurs within a range of the vehicle, a lightning bearing and a lightning range from the vehicle; and a bearing of the vehicle from one of the NDB radio navigation ground station or the AM radio broadcast station.
Example 20 includes the antenna receiver system of Example 19, wherein the at least one processor is one of: a digital processor; or at least two of a first analog processor, a second analog processor, and a third analog processor, wherein the first analog processor is configured to process the first, second, and third signals and output the information indicative of the bearing of the vehicle from one of the NDB radio navigation ground station or the AM radio broadcast station, wherein the second analog processor is configured to process the first, second, and third signals and output the information indicative of the geographical latitude and longitude position of the vehicle derived from the eLORAN radio navigation signals received from the three or more eLORAN ground stations, and wherein the third analog processor is configured to process the first, second, and third signals and output the information indicative of the lightning bearing and the lightning range from the vehicle.

Although specific embodiments have been illustrated and described herein, it will be appreciated by those of ordinary skill in the art that any arrangement, which can achieve the same purpose, may be substituted for the specific embodiments shown. Therefore, it is manifestly intended that this invention be limited only by the claims and the equivalents thereof.

## Claims

1. An antenna receiver system (20) comprising:
an E-field antenna (120) on a vehicle (60) with an omni-azimuth pattern;
a first H-field antenna (111) on the vehicle (60) with a cosine azimuth pattern with reference to a vehicle (60) orientation in a forward direction;
a second H-field antenna (112) on the vehicle (60) with a sine azimuth pattern with reference to the vehicle (60) orientation in the forward direction;
a first antenna radio frequency path (301, 306) to amplify, filter, and convert a first output from the first H-field antenna (111) to first signals (371);
a second antenna radio frequency path (302, 307) to amplify, filter, and convert a second output from the second H-field antenna (112) to second signals (372);
a third antenna radio frequency path (303, 307) to amplify, filter, and convert a third output from the E-field antenna (120) to third signals (373),
wherein filters (341-1, 341-2, 310-3) in the first, second, and third antenna radio frequency paths (301, 302, 303) are sufficiently wide to simultaneously receive at least two of:
eLORAN radio navigation signals (152) received from eLORAN ground stations (52-1, 52-2, 52-3);
an electromagnetic (EM) pulse (16) from lightning (15) within a range of the vehicle (60); and
one of: continuous wave (CW) unmodulated signals (151) received from a Non-Directional Beacons (NDB) radio navigation ground station (51-1, 51-2, 51-3, and 51-4); ON /OFF modulated signals (151) received from the NDB radio navigation ground station (51-1, 51-2, 51-3, and 51-4); or an amplitude modulated (AM) CW signal (151) received from an AM radio broadcast station (53-1); and
at least one processor (340) configured to process the first, second, and third signals (371, 372, 373) and output information indicative of two or more of:
a geographical latitude and a longitude position of the vehicle (60) derived from the eLORAN radio navigation signals (152) received from three or more eLORAN ground stations (52-1, 52-2, 52-3);
when lightning (15) occurs within a range of the vehicle (60), a lightning bearing and a lightning range from the vehicle (60); and
a bearing of the vehicle (60) from one of the NDB radio navigation ground station (51-1, 51-2, 51-3, and 51-4) or the AM radio broadcast station (53-1).

2. The antenna receiver system (20) of claim 1, wherein the NDB radio navigation ground station (51-1, 51-2, 51-3, or 51-4) includes a first ground navigation-aid transmitter (251),
wherein the AM broadcast station (51-3) includes an AM transmitter (253), and
wherein the three or more eLORAN ground stations (52-1, 52-2, 52-3) include three or more respective second ground navigation-aid transmitters (252) that emit the eLORAN radio navigation signals (152).

3. The antenna receiver system (20) of claim 1, wherein the at least one processor (340) is a digital processor (345).

4. The antenna receiver system (20) of claim 1, wherein the filters (341-1, 341-2, 310-3) in the first, second, and third antenna radio frequency paths (301, 302, 303) are sufficiently wide to simultaneously receive the eLORAN radio navigation signals (152), the EM pulse (16) from the lightning (15) occurring within the range of the vehicle (60), and one of: the CW unmodulated signals (151) received from the NDB radio navigation ground station (51-1, 51-2, 51-3, and 51-4); the ON /OFF modulated signals (151) received from the NDB radio navigation ground station (51-1, 51-2, 51-3, or 51-4); or the AM CW signal (151) received from the AM radio broadcast station (53-1), wherein the at least one processor (340) is configured to process the first, second, and third signals (371, 372, 373) and output the information indicative of:
the bearing of the vehicle (60) from one of the NDB radio navigation ground station (51-1, 51-2, 51-3, and 51-4) or the AM radio broadcast station (53-1);
the geographical latitude and longitude position of the vehicle (60) derived from the eLORAN radio navigation signals (152) received from the three or more eLORAN ground stations (52-1, 52-2, 52-3); and
when the lightning (15) occurs within the range of the vehicle (60), the lightning bearing and the lightning range from the vehicle (60).

5. The antenna receiver system (20) of claim 4, wherein the at least one processor (340) includes:
a first analog processor (341) configured to process the first, second, and third signals (371, 372, 373) and output the information indicative of the bearing of the vehicle (60) from one of the NDB radio navigation ground station (51-1, 51-2, 51-3, and 51-4) or the AM radio broadcast station (53-1);
a second analog processor configured to process the first, second, and third signals (371, 372, 373) and output the information indicative of the geographical latitude and longitude position of the vehicle (60) derived from the eLORAN radio navigation signals (152) received from the three or more eLORAN ground stations (52-1, 52-2, 52-3); and
a third analog processor configured to process the first, second, and third signals (371, 372, 373) and output the information indicative of the lightning bearing and the lightning range from the vehicle (60).

6. The antenna receiver system (20) of claim 1, wherein the filters (341-1, 341-2, 310-3) in the first, second, and third antenna radio frequency paths (301, 302, 303) are sufficiently wide to simultaneously receive the eLORAN radio navigation signals (152) and one of: the CW unmodulated signals (151) received from the NDB radio navigation ground station (51-1); the ON /OFF modulated signals (151) received from the NDB radio navigation ground station (51-2); or the AM CW signal (151) received from the AM radio broadcast station (53-1), and
wherein the at least one processor (340) is configured to process the first, second, and third signals and output the information indicative of:
the bearing of the vehicle (60) from one of the NDB radio navigation ground station or the AM radio broadcast station; and
the geographical latitude and longitude position of the vehicle derived from the eLORAN radio navigation signals received from the three or more eLORAN ground stations (52-1, 52-2, 52-3).

7. The antenna receiver system (20) of claim 1, wherein the filters (341-1, 341-2, 310-3) in the first, second, and third antenna radio frequency paths (301, 302, 303) are sufficiently wide to simultaneously receive the eLORAN radio navigation signals and the EM pulse from the lightning occurring within the range of the vehicle, wherein the at least one processor is configured to process the first, second, and third signals and output the information indicative of:
the geographical latitude and longitude position of the vehicle derived from the eLORAN radio navigation signals received from the three or more eLORAN ground stations (52-1, 52-2, 52-3); and
when the lightning occurs within the range of the vehicle, the lightning bearing and the lightning range from the vehicle.

8. The antenna receiver system (20) of claim 1, wherein the filters (341-1, 341-2, 310-3) in the first, second, and third antenna radio frequency paths (301, 302, 303) are sufficiently wide to simultaneously receive the EM pulse (16) from the lightning (15) occurring within the range of the vehicle (60), and one of: the CW unmodulated signals (151) received from the NDB radio navigation ground station (51-1); the ON /OFF modulated signals (151) received from the NDB radio navigation ground station (51-2); or the AM CW signal (151) received from the AM radio broadcast station (53-1), wherein the at least one processor (340) is configured to process the first, second, and third signals and output the information indicative of:
the bearing of the vehicle from one of the NDB radio navigation ground station or the AM radio broadcast station; and
when the lightning occurs within the range of the vehicle, the lightning bearing and the lightning range from the vehicle.

9. A method of implementing an antenna receiver system (20), the method comprising:
receiving signals arriving from any azimuth direction with an omni-azimuth pattern at an E-field antenna (120) on a vehicle (60);
receiving signals arriving from forward and aft of the vehicle (60) at a first H-field antenna (111) with a cosine azimuth pattern, the first H-field antenna (111) positioned on the vehicle (60);
receiving signals arriving from a starboard side and a port side of the vehicle (60) at a second H-field antenna (112) with a sine azimuth pattern, the second H-field antenna (112) positioned on the vehicle (60); and
simultaneously receiving at least two of:
eLORAN radio navigation signals (152);
an electromagnetic (EM) pulse (16) from lightning (15) within a range of the vehicle (60); and
one of: the (CW unmodulated signals received from the NDB radio navigation ground station; the ON /OFF modulated signals received from the NDB radio navigation ground station; or the AM CW signal received from the AM radio broadcast station
in a first antenna radio frequency path (301, 306), in a second antenna radio frequency path (302, 307), and in a third antenna radio frequency path (303, 307) by:
amplifying, filtering, and converting a first output from the first H-field antenna (111) to first signals (371) at the first antenna radio frequency path (301, 306);
amplifying, filtering, and converting a second output from the second H-field antenna (112) to second signals (372) at the second antenna radio frequency path (302, 307); and
amplifying, filtering, and converting a third output from the E-field antenna (120) to third signals (373) at the third antenna radio frequency path (303, 307).

10. The method of claim 9, further comprising:
processing at at least one processor the first, second, and third signals (371, 372, 373); and
outputting from the at least one processor information indicative of two or more of:
a bearing of the vehicle (60) from one of the NDB radio navigation ground station (51-1, 51-2, 51-3, and 51-4) or the AM radio broadcast station (53-1);
a geographical latitude and a longitude position of the vehicle (60) derived from the eLORAN radio navigation signals (152) received from the three or more eLORAN ground stations (52-1, 52-2, 52-3); and
when lightning (15) occurs within a range of the vehicle (60), a lightning bearing and a lightning range from the vehicle (60).
